# EUROPEAN PATENT APPLICATION

(11) **EP 4 195 894 A1**
(43) Date of publication of application: **14.06.2023**
(21) Application number: 21859805.0
(22) Date of filing: 18.06.2021
(51) Int. Cl.: H05K 7/20

(54) **HEAT DISSIPATION DEVICE AND MANUFACTURING METHOD THEREFOR**

(30) Priority: 24.08.2020 CN 202010854526
(71) Applicant: Huawei Technologies Co., Ltd., Longgang Shenzhen, Guangdong 518129 (CN)
(72) Inventor: PENG, Yaofeng, Shenzhen, Guangdong 518129 (CN)
(74) Representative: Isarpatent
(86) International application number: PCT/CN2021/100819
(87) International publication number: WO 2022/041961

(57) **Abstract**

This application provides a heat dissipation apparatus and a manufacturing method thereof, and relates to the field of hardware heat dissipation technologies, and may be applied to a small computing device disposed in an intelligent vehicle, an autonomous vehicle, a connected vehicle, or an electric vehicle. The heat dissipation apparatus includes a top layer, a plurality of plate thermos syphon PTS structures, and a bottom substrate. The PTS structures are disposed between the top layer and the bottom substrate and are perpendicular to the top layer and the bottom substrate. Second cavities that are of the PTS structures and that are enclosed by side walls communicate through a first cavity of the top layer. The second cavity contains a refrigerant. The heat dissipation apparatus uses a special heat dissipation structure such as the PTS structure, so that a heat dissipation effect of the heat dissipation apparatus can be significantly improved. In addition, because the cavities of the PTS structures communicate, vapor temperatures in the cavities of the PTS structures tend to be consistent, and heat dissipation performance of the heat dissipation apparatus can be effectively improved.

## Description

This application claims priority to Chinese Patent Application No. 202010854526.1, filed with the China National Intellectual Property Administration on August 24, 2020 and entitled "HEAT DISSIPATION APPARATUS AND MANUFACTURING METHOD THEREOF", which is incorporated herein by reference in its entirety.

### TECHNICAL FIELD

This application relates to the field of hardware heat dissipation technologies, and more specifically, to a heat dissipation apparatus and a manufacturing method thereof.

### BACKGROUND

As automotive intelligence technologies continuously develop, various electronic devices are used in a vehicle. Especially for a self-driving vehicle, there are many smart devices/systems used. A heat dissipation problem of these electronic devices in an operating process thus becomes prominent. A conventional vehicle-mounted radiator is usually a dust-proof, water-proof, and corrosion-resistant aluminum radiator. Some electronic devices with low power consumption may use natural heat dissipation, whereas some electronic devices with high power consumption use air-cooled heat dissipation. However, as electronic devices become smart, power consumption of electronic devices in a vehicle increases by dozens of times. In this case, a heat exchange area of the conventional vehicle-mounted radiator is obviously insufficient. If the heat exchange area of the radiator is to be increased, a height of a fin of the radiator needs to be increased. However, a larger height of the fin indicates a larger temperature difference between a bottom and a top of the fin. A heat exchange effect in a top area of the fin is quite poor, resulting in poor overall utilization efficiency of the fin and failure to meet a required heat dissipation effect.

Therefore, how to effectively improve a heat dissipation effect of the radiator is an urgent problem to be resolved.

### SUMMARY

This application provides a heat dissipation apparatus and a manufacturing method thereof, to effectively improve a heat dissipation effect of the heat dissipation apparatus.

According to a first aspect, a heat dissipation apparatus is provided. The heat dissipation apparatus includes a top layer, a plurality of plate thermos syphon PTS structures, and a bottom substrate. The top layer and the bottom substrate are disposed in parallel, the PTS structures are disposed between the top layer and the bottom substrate and are perpendicular to the bottom substrate, and a first end of the PTS structure is fastened on a surface that faces the top layer and that is of the bottom substrate. The top layer includes a first cover plate, a second cover plate, and a first cavity located between the first cover plate and the second cover plate. The PTS structure includes side walls and a second cavity enclosed by the side walls, and the side walls are connected to the second cover plate, to enable the second cavities of the plurality of PTS structures to communicate through the first cavity. The second cavity contains a refrigerant. The side walls and the bottom substrate are made of a thermally conductive metal material.

In the technical solution of this application, heat dissipation is performed in a two-phase heat exchange manner by using the PTS structure that is a special heat dissipation structure. An equivalent thermal conductivity coefficient (approximately 1000 W/mk to 20000 W/mk) of the PTS structure in a height direction (a direction from the bottom substrate to the top layer) is far greater than a thermal conductivity coefficient (approximately 100 W/mk to 200 W/mk) of conventional air-cooled metal fins. Therefore, a heat dissipation effect of the heat dissipation apparatus can be significantly improved. In addition, there is a small difference between a temperature of a top end (an end connected to the top layer) and a temperature of a bottom end (an end connected to the bottom substrate) of the PTS structure of the heat dissipation apparatus, achieving a better heat exchange effect. Moreover, because the cavities of the PTS structures communicate with each other, temperatures of steam in the cavities of the PTS structures can be enabled to tend to be consistent, effectively improving heat dissipation performance of the heat dissipation apparatus. Because of the large thermal conductivity coefficient, a volume of the heat dissipation apparatus can be reduced when a heat dissipation requirement is met, making it easier for the heat dissipation apparatus to be integrated in an electronic device requiring heat dissipation.

The heat dissipation apparatus in this embodiment of this application implements heat exchange through a phase change. Therefore, compared with a conventional air-cooled radiator conventional air cooling, the heat dissipation apparatus has quite little noise and is more suitable for a relatively closed environment such as a vehicle, improving users' use comfort. In addition, the heat dissipation apparatus in this embodiment of this application is made of a metal material such as aluminum flakes. When providing a same heat dissipation effect, the heat dissipation apparatus is far lighter than a conventional air-cooled radiator. Moreover, the heat dissipation apparatus in this embodiment of this application has a far lower requirement for thermal conductivity of a metal material than the conventional air-cooled radiator. Therefore, a relatively economical metal material may be selected for manufacturing, effectively reducing costs.

It should be noted that in this embodiment of this application, the first cover plate and the second cover plate may alternatively not be used for heat dissipation. In this case, the first cover plate and the second cover plate may not even be required to be thermally conductive, or they may not use a metal material. Therefore, in this case, steam mainly performs heat exchange with surfaces of the side walls in a rising process. However, to further improve a heat dissipation effect, the top layer may be made also available for heat dissipation. Specifically, the first cover plate and the second cover plate may be made available for heat dissipation.

With reference to the first aspect, in some implementations of the first aspect, the top layer is made of the thermally conductive metal material.

Optionally, the PTS structures and the bottom substrate may be made of the thermally conductive metal material, for example, pure metal such as aluminum, copper, or iron, or an alloy material such as an aluminum alloy, a copper alloy, or steel.

Optionally, materials used by different components may be the same or different. In other words, the top layer, the side walls of the PTS structures, and the bottom substrate may use a same metal material, or may use different metal materials, provided that a thermally conductive metal material is used.

With reference to the first aspect, in some implementations of the first aspect, to make the heat dissipation apparatus have good corrosion resistance, a corrosion-resistant metal material such as aluminum, copper, an aluminum alloy, or a copper alloy may be further selected to make the PTS structures and the bottom substrate. For example, the metal material may include at least one of the following: aluminum, copper, an aluminum alloy, or a copper alloy.

Optionally, to further improve a heat dissipation effect, a folded fin may be further disposed between at least two of the plurality of PTS structures to increase a heat exchange area, improving heat exchange efficiency.

With reference to the first aspect, in some implementations of the first aspect, the heat dissipation apparatus further includes a folded fin. The folded fin is connected between at least two adjacent PTS structures of the plurality of PTS structures. The folded fin is made of the thermally conductive metal material.

Optionally, the folded fin may be connected to the side walls in a welding manner.

Optionally, the folded fin may be made of the thermally conductive metal material, for example, pure metal such as aluminum, copper, or iron, or an alloy material such as an aluminum alloy, a copper alloy, or steel.

Optionally, to make the heat dissipation apparatus have good corrosion resistance, a corrosion-resistant metal material such as aluminum, copper, an aluminum alloy, or a copper alloy may be further selected as a material for making the folded fin.

Optionally, the folded fin may be of different shapes (structures), provided that the folded fin can be connected to the side walls of the plurality of PTS structures to increase a heat exchange area.

Optionally, to make the heat exchange area as large as possible, a quantity of folds of the folded fin may be increased, or it may be understood as that the folded fin may have a plurality of segments that are in contact with the side walls. Each transverse structure that is connected between two side walls and that is in the folded fin may be considered as a fold. An increase in a quantity of folds may lead to an increase in the heat exchange area. However, it should be noted that excessive folds also affect a heat dissipation effect. Therefore, the quantity of folds needs to be increased within a specific range.

With reference to the first aspect, in some implementations of the first aspect, there are a plurality of contact parts between the folded fin and the adjacent PTS structures.

With reference to the first aspect, in some implementations of the first aspect, the refrigerant is made of a volatile refrigerant substance that is liquid at normal temperature.

Optionally, various refrigerants that are liquid at normal temperature but have a low boiling point may be selected. For example, refrigerant substances such as tetrafluoroethane (R134), difluoromethane (R32), and pentafluoroethane (R125) may be selected as the refrigerant, or a refrigerant made from a mixture of a plurality of refrigerant substances, such as R410 (which is made from a mixture of R32 and R125), may be selected. Examples are not listed herein one by one.

Optionally, considering possible damage of the refrigerant to an environment, especially the ozone layer, an environmentally friendly substance such as R134 may be selected as the refrigerant.

According to a second aspect, a manufacturing method of a heat dissipation apparatus is provided. The manufacturing method includes: clamping components of a heat dissipation apparatus together by using tooling, and applying welding flux to all contact parts; melting the welding flux to weld the components together, to form an overall frame structure with a cavity; injecting a refrigerant from a liquid injection port; and sealing the liquid injection port through welding.

Optionally, the heat dissipation apparatus may be any heat dissipation apparatus in the first aspect. For example, the heat dissipation apparatus may include a top layer, a plurality of PTS structures, and a bottom substrate. The top layer and the bottom substrate are disposed in parallel, and the PTS structures are disposed between the top layer and the bottom substrate and are perpendicular to the bottom substrate. The PTS structure includes side walls and a second cavity enclosed by the side walls, and a first end of the side wall is in contact with the bottom substrate. A liquid injection port is disposed on the side wall of at least one of the plurality of PTS structures. The top layer includes a first cover plate and a second cover plate, both ends of the first cover plate are in contact with the second cover plate, a first cavity is formed between the first cover plate and the second cover plate, and the second cover plate is in contact with second ends of the side walls of each PTS structure, to enable the second cavities of the plurality of PTS structures to communicate with the first cavity. The top layer, the PTS structures, and the bottom substrate are made of a thermally conductive metal material.

In the technical solution of this application, an overall frame of the heat dissipation apparatus can be integrally formed, and subsequently, only injecting a refrigerant and sealing the liquid injection port need to be performed. This is convenient to operate and easy to implement, both improving production efficiency and improving quality of production to some extent. Contact points do not need to be welded one by one, and operation, assembly, and the like also do not need to be performed for a plurality of times. In addition, the manufactured heat dissipation apparatus has a better heat dissipation effect than a conventional radiator.

With reference to the second aspect, in some implementations of the second aspect, the metal material includes at least one of the following: aluminum, copper, an aluminum alloy, or a copper alloy.

With reference to the second aspect, in some implementations of the second aspect, a melting point of the welding flux is lower than a melting point of the metal material used by the top layer, the PTS structures, and the bottom substrate.

With reference to the second aspect, in some implementations of the second aspect, the heat dissipation apparatus further includes a folded fin. The folded fin is disposed between at least two adjacent PTS structures of the plurality of PTS structures. The welding flux may be applied to contact parts between the folded fin and the PTS structures. It should be noted that the folded fin is added between at least two adjacent PTS structures of the plurality of PTS structures, and the folded fin is in contact with the side walls of the at least two adjacent PTS structures at a plurality of points. Therefore, when the welding flux is applied, the welding flux is also applied to these contact parts. In a manufacturing process, only operations at a first step are slightly different (disposing the folded fin and applying the welding flux are added), and other steps do not change. In other words, even if the folded fin is added, the heat dissipation apparatus can still be formed at one time.

With reference to the second aspect, in some implementations of the second aspect, there are a plurality of contact parts between the folded fin and the adjacent PTS structures.

With reference to the second aspect, in some implementations of the second aspect, the refrigerant is made of a volatile refrigerant substance that is liquid at normal temperature.

### BRIEF DESCRIPTION OF DRAWINGS

FIG. 1 is a schematic diagram of a structure of a heat dissipation apparatus according to an embodiment of this application;
FIG. 2 is a schematic diagram of a heat dissipation process of a heat dissipation apparatus according to an embodiment of this application;
FIG. 3 is a schematic diagram of a structure of a heat dissipation apparatus according to an embodiment of this application;
FIG. 4 is a schematic diagram of several examples of a structure of a folded fin 25;
FIG. 5 is a schematic diagram of a three-dimensional structure of PTS structures 20 and folded fins 25;
FIG. 6 is a schematic diagram of a heat dissipation process of a heat dissipation apparatus according to an embodiment of this application;
FIG. 7 is a schematic flowchart of a manufacturing process of a heat dissipation apparatus according to an embodiment of this application;
FIG. 8 and FIG. 9 are schematic diagrams of structures of components of a heat dissipation apparatus in a manufacturing process according to an embodiment of this application;
FIG. 10 and FIG. 11 are schematic diagrams of injecting a refrigerant into cavities of a heat dissipation apparatus according to an embodiment of this application; and
FIG. 12 is a schematic diagram of sealing a liquid injection port according to an embodiment of this application.

### DESCRIPTION OF EMBODIMENTS

The following describes technical solutions in embodiments of this application with reference to accompanying drawings in embodiments of this application.

A conventional air-cooled radiator mainly rotates a fan to accelerate air circulation, to dissipate heat as quickly as possible. If a heat dissipation effect of the radiator is to be improved, the following several manners may be used for implementation.

A first manner is to increase a rotational speed of the fan, to improve a heat exchange capability of the radiator. However, this improvement is not significant and may further cause a heating-up problem of the radiator. In addition, there is a significant increase in noise. If the radiator is installed in a relatively closed environment such as in a vehicle, users' use experience is quite poor.

A second manner is to increase a thickness of a fin. After the thickness of the fin is increased, thermal conduction resistance from a bottom to a top of the fin decreases, a temperature difference decreases, but a weight of the radiator increases. In addition, after the thickness of the fin is increased, a quantity of fins decreases in a same area, and heat exchange performance of the radiator may not be improved but deteriorate.

A third manner is to replace a material of a fan with a material with a larger thermal conductivity coefficient. For example, a fan made of die casting aluminum (a type of aluminum alloy) with a thermal conductivity coefficient of 100 watts/meter×degree (W/mk) may be replaced with a fan made of machined aluminum 6061 (another type of aluminum alloy) with a thermal conductivity coefficient of 180 W/mk. However, after the replacement, the thermal conductivity coefficient does not significantly increase, improvement of heat dissipation performance is quite limited, and costs significantly increase.

It can be learned that, regardless of how the conventional air-cooled radiator is improved, it is difficult to achieve an ideal heat dissipation effect. For this case, an embodiment of this application provides a heat dissipation apparatus in a new structural form, to effectively improve a heat dissipation effect.

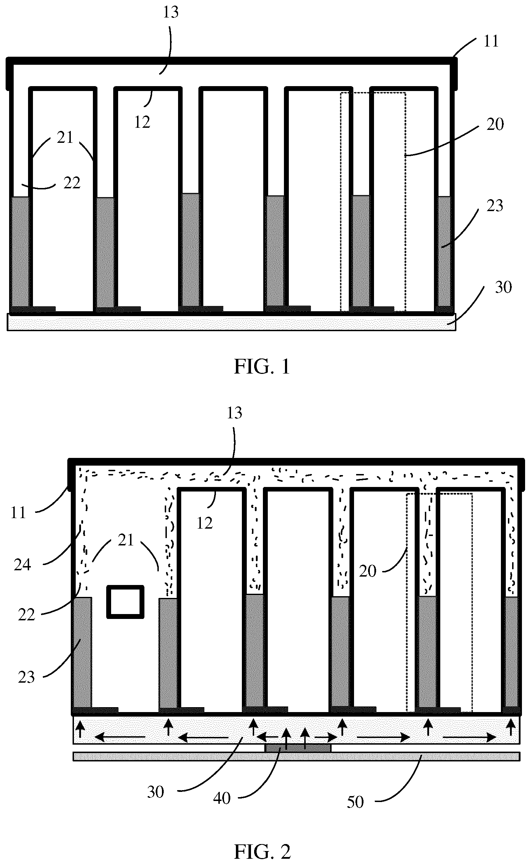

FIG. 1 is a schematic diagram of a structure of a heat dissipation apparatus according to an embodiment of this application. As shown in FIG. 1, the heat dissipation apparatus includes a top layer, a plurality of plate thermos syphon (plate thermos syphon, PTS) structures 20, and a bottom substrate 30. The top layer and the bottom substrate 30 are disposed in parallel. The plurality of PTS structures 20 are disposed between the top layer and the bottom substrate 30 and are perpendicular to the top layer and the bottom substrate 30. First ends of the plurality of PTS structures 20 are fastened on a surface (which may be understood as an upper surface of the bottom substrate 30) that faces the top layer and that is of the bottom substrate 30.

The top layer includes a first cover plate 11, a second cover plate 12, and a first cavity (first hollow cavity) 13 located between the first cover plate 11 and the second cover plate 12.

Each PTS structure 20 includes side walls 21 and a second cavity (second hollow cavity) 22 enclosed by the side walls 21. The side walls 21 of each of the plurality of PTS structures 20 are connected to the second cover plate 12, to enable the second cavity 22 of each PTS structure 20 to communicate with the first cavity 13. In other words, the plurality of second cavities 22 may communicate with each other through the first cavity 13.

Optionally, the side walls 21 may be made of a thermally conductive metal material, for example, pure metal such as aluminum, copper, or iron, or an alloy material such as an aluminum alloy, a copper alloy, or steel.

Optionally, to make the heat dissipation apparatus have good corrosion resistance, a corrosion-resistant metal material such as aluminum, copper, an aluminum alloy, or a copper alloy may be further selected to make the side walls 21.

Optionally, to reduce costs as much as possible while meeting a heat dissipation requirement, an aluminum alloy may be further selected as a material for making the side walls 21. For example, two aluminum flakes may be welded to form a hollow PTS structure.

It should be understood that because the side walls 21 only need to be made of a thermally conductive metal material, the heat dissipation apparatus in this embodiment of this application has a far lower requirement for a material than a conventional air-cooled radiator. For example, it is not required that the aluminum flakes need to be made of an expensive aluminum alloy material with a quite large thermal conductivity coefficient. In other words, a requirement for a thermal conductivity coefficient of the aluminum flakes is relatively low. Therefore, costs can be effectively reduced.

It should be noted that the first cover plate 11 and the second cover plate 12 may also be made of a metal material, may use a same material as the side walls 21, or may use a different material than the side walls 21. This is not limited. It should be further understood that in this embodiment of this application, the first cover plate 11 and the second cover plate 12 may alternatively not be used for heat dissipation. In this case, the first cover plate 11 and the second cover plate 12 may not even be required to be thermally conductive, or they may not use a metal material. However, using the first cover plate 11 and the second cover plate 12 for heat dissipation can further increase a heat exchange area, further improving a heat dissipation effect.

Optionally, first ends (bottoms of the side walls 21 shown in FIG. 1) of the side walls 21 and the bottom substrate 30 may be welded (for example, soldered) together for sealing. The first ends of the side walls 21 are fastened on the upper surface of the bottom substrate 30. Optionally, the side walls 21 may be fastened on the upper surface of the bottom substrate 30 in a manner of welding, for example, soldering.

Optionally, the second cavities 22 may be filled with a volatile refrigerant 23. A refrigerant is a substance used by various cooling devices to complete energy conversion, and is also referred to as a working substance for completing a thermodynamic cycle. An energy conversion process is usually implemented through a phase change. For example, a phase change from a gas state to a liquid state releases a large amount of heat, whereas a phase change from the liquid state to the gas state absorbs a large amount of heat. In this embodiment of this application, a volatile refrigerant (that is, a substance easy to perform a phase change from the liquid state to the gas state) is selected. Under a normal condition (for example, at normal temperature), the refrigerant is in the liquid state, for example, the liquid refrigerant 23 shown in FIG. 1. When the heat dissipation apparatus operates, a bottom (an end close to the bottom substrate 30) of the PTS structure 20 is heated. As a result, a temperature of the refrigerant 23 rises, and a phase change occurs (from the liquid state to the gas state). The phase change process absorbs heat from the bottom (that is, heat transferred from the bottom substrate 30), playing a role of cooling and heat dissipation. A specific process is described in FIG. 2, and details are not described herein.

Optionally, various refrigerants that are liquid at normal temperature but have a low boiling point may be selected. For example, refrigerant substances such as tetrafluoroethane (R134), difluoromethane (R32), and pentafluoroethane (R125) may be selected as the refrigerant, or a refrigerant made from a mixture of a plurality of refrigerant substances, such as R410 (which is made from a mixture of R32 and R125), may be selected. Examples are not listed herein one by one.

Optionally, considering possible damage of the refrigerant to an environment, especially the ozone layer, an environmentally friendly substance such as R134 may be selected as the refrigerant.

The bottom substrate 30 may be used to transfer heat of an object (which may be, for example, an electronic device whose heat is to be dissipated such as a device, a chip, or a component) that needs to be cooled to the PTS structures 20. Specifically, the bottom substrate 30 absorbs heat of an object to be cooled, and transfers the heat of the object to be cooled to the first ends of the side walls 21 of the PTS structures connected to the bottom substrate 30.

Optionally, the bottom substrate 30 may be made of a thermally conductive metal material, for example, pure metal such as aluminum, copper, or iron, or an alloy material such as an aluminum alloy, a copper alloy, or steel.

Optionally, to make the heat dissipation apparatus have good corrosion resistance, a corrosion-resistant metal material such as aluminum, copper, an aluminum alloy, or a copper alloy may be further selected to make the bottom substrate 30.

Optionally, a material of the bottom substrate 30 may be the same as or different from materials of other parts. In other words, the top layer, the side walls 21 of the PTS structures 20, and the bottom substrate 30 may use a same metal material, or may use different metal materials, provided that a thermally conductive metal material is used.

FIG. 2 is a schematic diagram of a heat dissipation process of a heat dissipation apparatus according to an embodiment of this application. As shown in FIG. 2, a surface (a lower surface of the bottom substrate 30) of a side that is far away from the top layer and that is of the bottom substrate 30 is pressed against an electronic device 40 whose heat is to be dissipated. The electronic device 40 whose heat is to be dissipated may be a device, a chip, a component, an electronic module, or the like. In other words, the heat dissipation apparatus in this embodiment of this application may be integrated inside some electronic devices whose heat needs to be dissipated, and be in contact with a module that is expected to be protected by cooling; or may be a separate heat dissipation apparatus, and only the bottom substrate 30 of the heat dissipation apparatus needs to be pressed against an area that emits heat.

For ease of understanding, the following uses an example for description in which the electronic device 40 whose heat is to be dissipated is a chip. In the example, the lower surface of the bottom substrate 30 is pressed against a chip (an example of the electronic device 40 whose heat is to be dissipated), and the chip is located on a surface of a printed circuit board 50.

After the chip heats up (a temperature rises and is greater than a temperature of the bottom substrate 30), heat of the chip is transferred to the bottom substrate 30 through a physical contact surface of the lower surface of the bottom substrate 30, further transferred, through the bottom substrate 30, to the first ends of the side walls 21 connected to the bottom substrate 30, and then transferred to the refrigerant 23 in the second cavities 22. The refrigerant 23 evaporates quickly after being heated. The evaporation process absorbs heat. Through evaporation, steam 24 of the refrigerant 23 is generated. In a rising (moving in a direction towards the top layer) process, the steam 24 performs heat exchange with surfaces of the side walls 21, a surface of the first cover plate 11, and a surface of the second cover plate 12. Heat is dissipated into air. After heat of the steam 24 is dissipated, the steam 24 liquefies, is re-converted into the refrigerant 23 that is in the liquid state, flows down to bottoms of the second cavities 22 along the surfaces of the side walls 21, that is, flows in a direction towards the bottom substrate 30, and finally melts into the original refrigerant 23, to enter a next round of heat exchange (gasification-liquefaction).

It should be noted that when the cavities of the plurality of PTS structures 20 communicate with each other (that is, the plurality of second cavities 22 communicate with each other through the first cavity 13), temperatures of the steam 24 in the second cavities 22 can be enabled to tend to be consistent, effectively improving heat dissipation performance of the heat dissipation apparatus.

It should be further noted that, as described above, in this embodiment of this application, the first cover plate 11 and the second cover plate 12 may alternatively not be used for heat dissipation. In this case, the first cover plate 11 and the second cover plate 12 may not even be required to be thermally conductive, or they may not use a metal material. Therefore, in this case, the steam 24 mainly performs heat exchange with the surfaces of the side walls 21 in the rising process.

The heat dissipation apparatus in this embodiment of this application performs heat dissipation in a two-phase heat exchange manner by using the PTS structure that is a special heat dissipation structure. An equivalent thermal conductivity coefficient (approximately 1000 W/mk to 20000 W/mk) of the PTS structure in a height direction (a direction from the bottom substrate 30 to the top layer) is far greater than a thermal conductivity coefficient (approximately 100 W/mk to 200 W/mk) of conventional air-cooled metal fins. Therefore, the heat dissipation effect of the heat dissipation apparatus can be significantly improved. In addition, there is a small difference between a temperature of a top end (an end connected to the top layer) and a temperature of a bottom end (an end connected to the bottom substrate) of the PTS structure of the heat dissipation apparatus, achieving a better heat exchange effect. Moreover, because the cavities of the PTS structures communicate with each other, the temperatures of the steam in the cavities of the PTS structures can be enabled to tend to be consistent, effectively improving heat dissipation performance of the heat dissipation apparatus. Because of the large thermal conductivity coefficient, a volume of the heat dissipation apparatus can be reduced when a heat dissipation requirement is met, making it easier for the heat dissipation apparatus to be integrated in an electronic device requiring heat dissipation.

The heat dissipation apparatus in this embodiment of this application implements heat exchange through a phase change. Therefore, compared with a conventional air-cooled radiator, the heat dissipation apparatus has quite little noise and is more suitable for a relatively closed environment such as a vehicle, improving users' use comfort. In addition, the heat dissipation apparatus in this embodiment of this application is made of a metal material such as aluminum flakes. When providing a same heat dissipation effect, the heat dissipation apparatus is far lighter than a conventional air-cooled radiator. Moreover, the heat dissipation apparatus in this embodiment of this application has a far lower requirement for thermal conductivity of a metal material than the conventional air-cooled radiator. Therefore, a relatively economical metal material may be selected for manufacturing, effectively reducing costs.

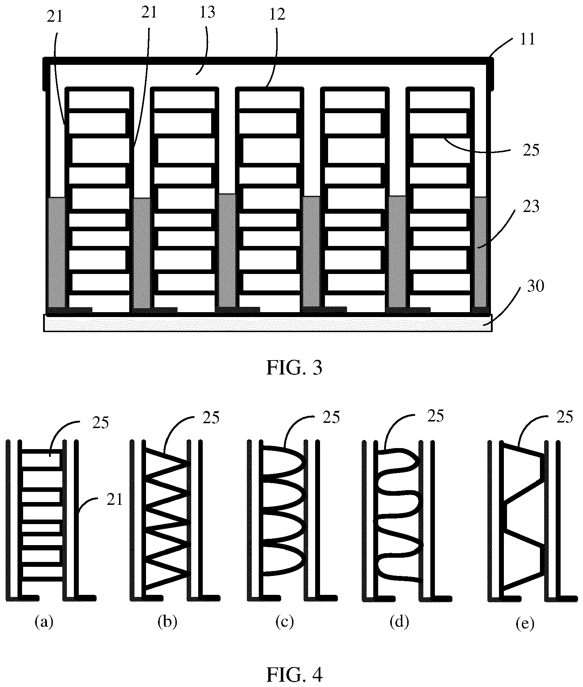

Optionally, to further improve the heat dissipation effect, a folded fin may be further disposed between at least two of the plurality of PTS structures 20 to increase the heat exchange area, improving heat exchange efficiency. The following provides a description with reference to FIG. 3 to FIG. 6.

FIG. 3 is a schematic diagram of a structure of a heat dissipation apparatus according to an embodiment of this application. As shown in FIG. 3, the heat dissipation apparatus includes a top layer, a plurality of PTS structures 20, and a bottom substrate 30. In addition, a folded fin 25 is connected between at least two adjacent PTS structures of the plurality of PTS structures 20, so that the folded fin 25 can perform heat transfer with connected side walls 21.

It should be noted that when FIG. 3 is compared with FIG. 1, only the folded fin 25 is added, and other structures are exactly the same. Therefore, for brevity, appropriate omission is made. For content of an omitted part, refer to related descriptions in FIG. 1 and FIG. 2.

As shown in FIG. 3, the folded fin (folded fin) 25 connects side walls 21 of two PTS structures, increasing a heat exchange area. In other words, heat of the side walls 21 can be transferred to the folded fin 25 and then dissipated through the folded fin 25.

Optionally, the folded fin 25 may be connected to the side walls 21 in a welding manner.

Optionally, the folded fin 25 may be made of a thermally conductive metal material, for example, pure metal such as aluminum, copper, or iron, or an alloy material such as an aluminum alloy, a copper alloy, or steel.

Optionally, to make the heat dissipation apparatus have good corrosion resistance, a corrosion-resistant metal material such as aluminum, copper, an aluminum alloy, or a copper alloy may be further selected as a material for making the folded fin 25.

Optionally, the folded fin 25 may be of different shapes (structures), provided that the folded fin 25 can be connected to the side walls 21 of the plurality of PTS structures to increase the heat exchange area.

Optionally, to make the heat exchange area as large as possible, a quantity of folds of the folded fin 25 may be increased, or it may be understood as that the folded fin 25 may have a plurality of segments that are in contact with the side walls 21. As shown in FIG. 3, each transverse structure that is connected between two side walls 21 and that is in the folded fin 25 may be considered as a fold. An increase in a quantity of folds may lead to an increase in the heat exchange area. However, it should be noted that excessive folds also affect a heat dissipation effect. Therefore, the quantity of folds needs to be increased within a specific range.

Experiments indicate that under same other conditions, when the heat dissipation apparatus with the structure shown in FIG. 3 described above is compared with a conventional air-cooled radiator, a thermal conductivity coefficient of the fin can be increased by 5.6 to 111.1 times, a temperature difference (a difference between temperatures of two ends of the fin) of the fin is reduced from 9 degrees Celsius (°C) to less than 1.3°C, and heat dissipation performance is improved by more than 40%.

FIG. 4 is a schematic diagram of several examples of a structure of a folded fin 25. A folded fin 25 shown in (a) in FIG. 4 is of an arcuate structure. A folded fin 25 shown in (b) in FIG. 4 is of a zigzag structure. A folded fin 25 shown in (c) in FIG. 4 is of a parabolic (or may be considered as semicircular) structure. A folded fin 25 shown in (d) in FIG. 4 is of an irregular wavy structure. A folded fin 25 shown in (e) in FIG. 4 is of a trapezoidal structure.

It should be noted that a shape of the folded fin 25 is not limited in this embodiment of this application. However, selecting a regular shape makes it easy to process. For example, a shape in (a), (b), (c), or (e) in FIG. 4 may be selected. In addition, the folded fins 25 in the two solutions of (a) and (e) in FIG. 4 have a relatively large area that is in contact with side walls 21. When the folded fins 25 in the two solutions of (a) and (e) are compared with the folded fins 25 in the three solutions of (b), (c), and (d), it is easier to transfer heat from the side walls 21 to the folded fins 25 in the two solutions of (a) and (e).

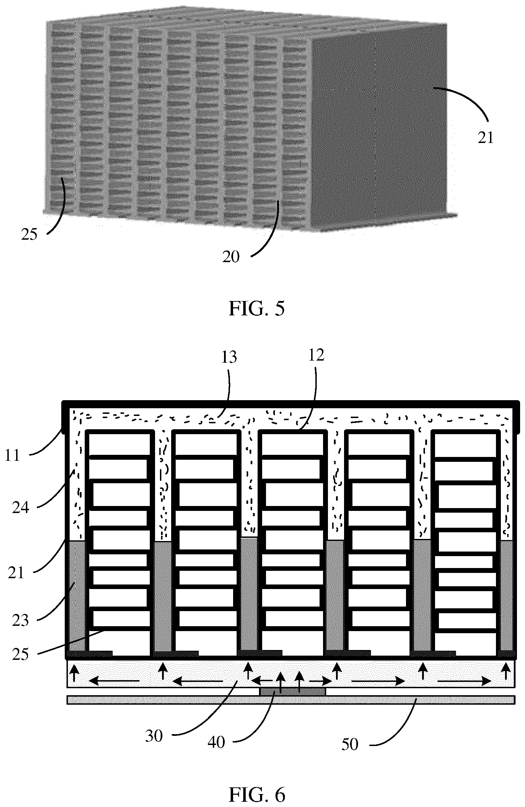

FIG. 5 is a schematic diagram of a three-dimensional structure of PTS structures 20 and folded fins 25. A shape of the folded fin 25 in FIG. 5 corresponds to a shape shown in (a) in FIG. 4.

It can be learned from FIG. 5 that every two adjacent PTS structures 20 are connected by using the folded fin 25. Specifically, the folded fin 25 is connected to both opposite side walls 21 of every two adjacent PTS structures 20.

FIG. 6 is a schematic diagram of a heat dissipation process of a heat dissipation apparatus according to an embodiment of this application. It should be noted that when FIG. 6 is compared with FIG. 2, only the folded fin 25 is added, and other structures are exactly the same. Therefore, for brevity, appropriate omission is made. For content of an omitted part, refer to related descriptions in FIG. 2.

For ease of understanding, the following uses an example for description in which the electronic device 40 whose heat is to be dissipated is a chip. In the example, a lower surface of the bottom substrate 30 is pressed against a chip (an example of the electronic device 40 whose heat is to be dissipated), and the chip is located on a surface of a printed circuit board 50.

After the chip heats up (a temperature rises and is greater than a temperature of the bottom substrate 30), heat of the chip is transferred to the bottom substrate 30 through a physical contact surface of the lower surface of the bottom substrate 30, further transferred, through the bottom substrate 30, to first ends of the side walls 21 connected to the bottom substrate, and then transferred to a refrigerant 23 in second cavities 22. The refrigerant 23 evaporates quickly after being heated. The evaporation process absorbs heat. Through evaporation, steam 24 of the refrigerant 23 is generated. In a rising (moving in a direction towards the top layer) process, the steam 24 performs heat exchange with surfaces of the side walls 21, a surface of a first cover plate 11, and a surface of a second cover plate 12. Heat is dissipated into air. In addition, because the side walls 21 are connected to the folded fin 25, a portion of the heat is transferred to the folded fin 25, and then dissipated into air from the folded fin 25. Due to presence of the folded fin 25, a transfer direction of the portion of the heat is not marked in FIG. 6. After heat of the steam 24 is dissipated, the steam 24 liquefies, is re-converted into the refrigerant 23 that is in a liquid state, flows down to bottoms of the second cavities 22 along the surfaces of the side walls 21, that is, flows in a direction towards the bottom substrate 30, and finally melts into the original refrigerant 23, to enter a next round of heat exchange (gasification-liquefaction).

It should be noted that when the cavities of the plurality of PTS structures 20 communicate with each other (that is, the plurality of second cavities 22 communicate with each other through a first cavity 13), temperatures of the steam 24 in the second cavities 22 can be enabled to tend to be consistent, effectively improving heat dissipation performance of the heat dissipation apparatus.

It should be further noted that, as described above, in this embodiment of this application, the first cover plate 11 and the second cover plate 12 may alternatively not be used for heat dissipation. In this case, the first cover plate 11 and the second cover plate 12 may not even be required to be thermally conductive, or they may not use a metal material. Therefore, in this case, in the rising process, the steam 24 mainly performs heat exchange with the surfaces of the side walls 21, and dissipates heat through the folded fin 25 connected to the side walls 21.

For a conventional radiator, each component is relatively independent and therefore needs to be produced separately. In addition, an assembly process requiring many steps affects production efficiency. Besides, more links result in a larger probability that a quality problem occurs and a higher requirement for a process. This application provides a manufacturing method of a heat dissipation apparatus, capable of forming a heat dissipation apparatus at one time and effectively improving production efficiency.

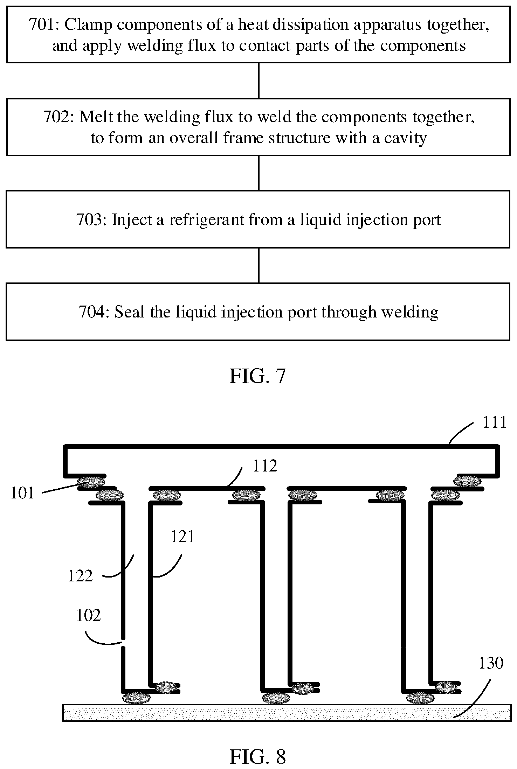

FIG. 7 is a schematic flowchart of a manufacturing process of a heat dissipation apparatus according to an embodiment of this application. The following describes steps in FIG. 7. It should be noted that for ease of understanding the steps in the manufacturing process described in FIG. 7, a description is provided with reference to FIG. 8 to FIG. 11. FIG. 8 to FIG. 11 show structures of the heat dissipation apparatus and states of components in different manufacturing steps.

701: Clamp the components of the heat dissipation apparatus together, and apply welding flux to contact parts of the components.

As shown in FIG. 8, the components of the heat dissipation apparatus include a top layer, a plurality of PTS structures, and a bottom substrate 130. The top layer and the bottom substrate 130 are disposed in parallel. The plurality of PTS structures are disposed between the top layer and the bottom substrate 130 and are perpendicular to the top layer and the bottom substrate 130. First ends of the plurality of PTS structures are in contact with a surface (which may be understood as an upper surface of the bottom substrate 30) that faces the top layer and that is of the bottom substrate 130.

Each of the plurality of PTS structures includes side walls 121 and a second cavity 122 enclosed by the side walls 121. A first end (an end close to the bottom substrate 130) of the side wall 121 is in contact with the bottom substrate 130.

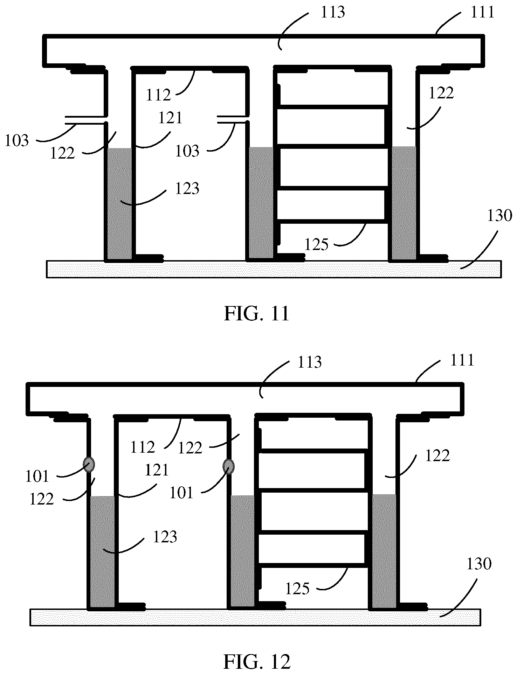

A liquid injection port 102 is disposed on the side wall 121 of at least one of the plurality of PTS structures. FIG. 8 to FIG. 10 show cases that exist when there is only one liquid injection port 102. FIG. 11 and FIG. 12 show cases that exist when there are a plurality of liquid injection ports 102. In other words, the liquid injection port may be disposed on only one PTS structure, and liquid can be injected into each PTS structure because a first cavity and the second cavities communicate with each other. However, disposing a plurality of liquid injection ports or even separately disposing a liquid injection port on each PTS structure makes it more convenient to inject the liquid (inject a refrigerant).

The top layer includes a first cover plate 111 and a second cover plate 112. Both ends of the first cover plate 11 are in contact with the second cover plate 112. The first cavity may be formed between the first cover plate 111 and the second cover plate 112. The second cover plate 112 is in contact with second ends (ends far away from the bottom substrate 30) of the side walls 121 of each PTS structure, to enable the second cavity of each PTS structure to separately communicate with the first cavity in the top layer.

Optionally, the components may be clamped together by using tooling.

Optionally, welding flux (for example, solder) 101 may be applied to each of the contact parts. As shown in FIG. 8, each gray oval indicates the welding flux 101.

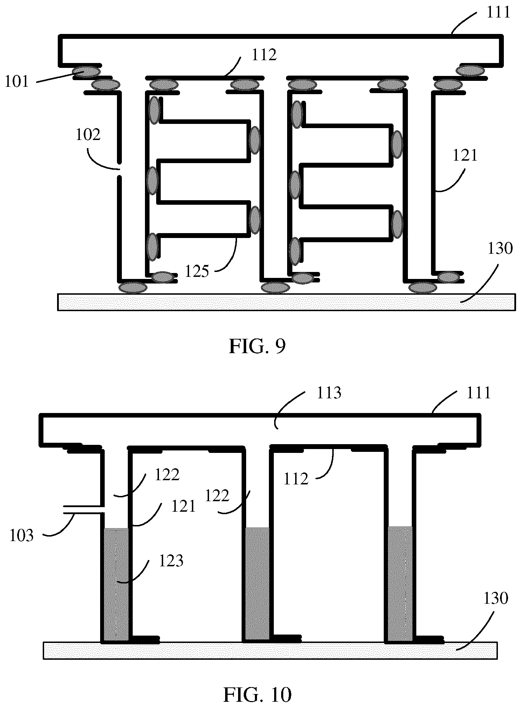

FIG. 8 and FIG. 9 are schematic diagrams of structures of components of a heat dissipation apparatus in a manufacturing process according to an embodiment of this application. The heat dissipation apparatus in FIG. 8 does not include a folded fin, whereas the heat dissipation apparatus in FIG. 9 includes a folded fin 125. In other words, regardless of how many components the heat dissipation apparatus includes, all components of the heat dissipation apparatus may be clamped together, and the welding flux may be applied to each contact part in Step 701. This manufacturing manner can make a frame of the heat dissipation apparatus to be integrally formed, both improving production efficiency and improving quality of production to some extent.

It should be noted that FIG. 9 differs from FIG. 8 only in that the folded fin 125 is added between at least two adjacent PTS structures of a plurality of PTS structures, and the folded fin 125 is in contact with side walls 121 of the at least two adjacent PTS structures at a plurality of points. Therefore, when the welding flux is applied, the welding flux is also applied to these contact parts, as shown in FIG. 9.

Optionally, in this embodiment of this application, the components may use any of thermally conductive metal materials described above.

Optionally, the components may use materials with good corrosion resistance such as aluminum, copper, an aluminum alloy, and a copper alloy. To reduce costs, the aluminum alloy may be further selected from the materials.

Optionally, the welding flux 101 may also use a thermally conductive metal material.

Optionally, for a better implementation effect, a melting temperature of the welding flux is lower than a melting temperature of each component.

Optionally, the components and the welding flux 101 may all use an aluminum alloy.

It should be noted that a size of the heat dissipation apparatus in this embodiment of this application is not limited. For example, none of a height of the side wall of the PTS structure, a width of the top layer, or the like is limited, provided that the structure can be formed. When the heat dissipation apparatus is used to dissipate heat for a chip and an electronic component, the heat dissipation apparatus may be made small in size, whereas when the heat dissipation apparatus is used to dissipate heat for a large electronic device, a large size may be designed.

702: Melt the welding flux to weld the components together, to form an overall frame structure with a cavity.

Optionally, the entire heat dissipation apparatus obtained after Step 701 is performed may be placed in a soldering furnace for heating, so that the welding flux melts and makes all the contact parts bond with their adjacent parts, to form the overall frame structure with the cavity.

703: Inject a refrigerant from the liquid injection port.

Optionally, when there is only one liquid injection port 102, a liquid injection pipe 103 is connected to the liquid injection port 102 to inject the refrigerant 123. When there are a plurality of liquid injection ports 102, liquid injection pipes 103 are connected to the plurality of liquid injection ports 102 to inject the refrigerant 123.

FIG. 10 and FIG. 11 are schematic diagrams of injecting a refrigerant into cavities of a heat dissipation apparatus according to an embodiment of this application. It should be noted that because FIG. 10 and FIG. 11 are mainly intended to describe liquid injection, whether the heat dissipation apparatus includes a folded fin is not limited. For example, the heat dissipation apparatus shown in FIG. 10 has only one liquid injection port, but the heat dissipation apparatus may be the heat dissipation apparatus shown in FIG. 8 or the heat dissipation apparatus shown in FIG. 9. As shown in FIG. 11, the heat dissipation apparatus includes a plurality of liquid injection ports 102. In this case, the liquid injection pipe 103 may be connected to each liquid injection port 102 to inject the refrigerant.

Optionally, before the refrigerant is injected, air in the cavities may be pumped out from the liquid injection port. This can improve a heat exchange effect.

Optionally, for ease of implementation, a liquid level of the refrigerant 123 is not higher than a height of the liquid injection port 102. Alternatively, a volume of the refrigerant 123 may be determined based on the height of the side wall 121.

704: Seal the liquid injection port through welding.

Optionally, after Step 703 is performed, the liquid injection port 102 may be welded up, so that the cavities of the heat dissipation apparatus become a completely closed structure.

Optionally, each liquid injection port 102 may be sealed through welding by using the welding flux 101. FIG. 12 is a schematic diagram of sealing a liquid injection port according to an embodiment of this application. FIG. 12 may be considered as an operation that is further performed on a basis of FIG. 11. In other words, each liquid injection port 102 is sealed by using the welding flux 101. However, it should be understood that FIG. 12 is merely an example. In this embodiment of this application, when a specific quantity of liquid injection ports are disposed in Step 701, the same quantity of liquid injection ports need to be sealed through welding in Step 704. The quantity and specific locations of the liquid injection ports are not limited.

Optionally, an embodiment of this application further provides an electronic device. The electronic device has any of the heat dissipation apparatuses in embodiments of this application described above.

In the manufacturing method shown in FIG. 7, the overall frame of the heat dissipation apparatus can be integrally formed, and subsequently, only injecting the refrigerant and sealing the liquid injection port need to be performed. This is convenient to operate and easy to implement, both improving production efficiency and improving quality of production to some extent. Contact points do not need to be welded one by one, and operation, assembly, and the like also do not need to be performed for a plurality of times. In addition, the manufactured heat dissipation apparatus has a better heat dissipation effect than a conventional radiator.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation apparatus, wherein the heat dissipation apparatus comprises a top layer, a plurality of plate thermos syphon PTS structures, and a bottom substrate;
the top layer and the bottom substrate are disposed in parallel, the PTS structures are disposed between the top layer and the bottom substrate and are perpendicular to the bottom substrate, and a first end of the PTS structure is fastened on a surface that is of the bottom substrate and that faces the top layer;
the top layer comprises a first cover plate, a second cover plate, and a first cavity located between the first cover plate and the second cover plate;
the PTS structure comprises side walls and a second cavity enclosed by the side walls, and the side walls are connected to the second cover plate, to enable the second cavities of the plurality of PTS structures to communicate through the first cavity;
the second cavity contains a refrigerant; and
the side walls and the bottom substrate are made of a thermally conductive metal material.

2. The heat dissipation apparatus according to claim 1, wherein the top layer is made of the thermally conductive metal material.

3. The heat dissipation apparatus according to claim 1 or 2, wherein the metal material comprises at least one of the following: aluminum, copper, aluminum alloy, and copper alloy.

4. The heat dissipation apparatus according to any one of claims 1 to 3, wherein the heat dissipation apparatus further comprises a folded fin, the folded fin is connected between at least two adjacent PTS structures of the plurality of PTS structures, and the folded fin is made of the thermally conductive metal material.

5. The heat dissipation apparatus according to claim 4, wherein there are a plurality of contact parts between the folded fin and the adjacent PTS structures.

6. The heat dissipation apparatus according to any one of claims 1 to 5, wherein the refrigerant is made of a volatile refrigerant substance that is liquid at a normal temperature.

7. A manufacturing method of a heat dissipation apparatus, wherein the heat dissipation apparatus comprises a top layer, a plurality of PTS structures, and a bottom substrate, the top layer and the bottom substrate are disposed in parallel, and the PTS structures are disposed between the top layer and the bottom substrate and are perpendicular to the bottom substrate;
the PTS structure comprises side walls and a second cavity enclosed by the side walls, and a first end of the side wall is in contact with the bottom substrate;
a liquid injection port is disposed on the side wall of at least one of the plurality of PTS structures;
the top layer comprises a first cover plate and a second cover plate, both ends of the first cover plate are in contact with the second cover plate, a first cavity is formed between the first cover plate and the second cover plate, and the second cover plate is in contact with second ends of the side walls of each PTS structure, to enable the second cavities of the plurality of PTS structures to communicate with the first cavity; and
the top layer, the PTS structures, and the bottom substrate are made of a thermally conductive metal material; and
the manufacturing method includes:
clamping the top layer, the plurality of PTS structures, and the bottom substrate together by using tooling, and applying welding flux to all contact parts;
melting the welding flux to weld the top layer, the plurality of PTS structures, and the bottom substrate together, to form an overall frame structure with a cavity;
injecting a refrigerant from the liquid injection port; and
sealing the liquid injection port through welding.

8. The manufacturing method according to claim 7, wherein the metal material comprises at least one of the following: aluminum, copper, aluminum alloy, and copper alloy.

9. The manufacturing method according to claim 7 or 8, wherein a melting point of the welding flux is lower than a melting point of the metal material used by the top layer, the PTS structures, and the bottom substrate.

10. The manufacturing method according to any one of claims 7 to 9, wherein the heat dissipation apparatus further comprises a folded fin, and the folded fin is disposed between at least two adjacent PTS structures of the plurality of PTS structures; and
the manufacturing method further comprises:
applying the welding flux to contact parts between the folded fin and the PTS structures.

11. The manufacturing method according to claim 10, wherein there are a plurality of contact parts between the folded fin and the adjacent PTS structures.

12. The manufacturing method according to any one of claims 7 to 11, wherein the refrigerant is made of a volatile refrigerant substance that is liquid at normal temperature.
